# EUROPÄISCHE PATENTSCHRIFT

(11) **EP 3 494 375 B1**
(45) Veröffentlichungstag und Bekanntmachung des Hinweises auf die Patenterteilung: **01.11.2023**
(21) Anmeldenummer: 17772611.4
(22) Anmeldetag: 03.08.2017
(51) Int. Cl.: F16P 3/14, G01L 1/20

(54) **SCHUTZEINRICHTUNG ZUR ÜBERWACHUNG EINER TECHNISCHEN ANLAGE MIT EINEM DRUCKEMPFINDLICHEN SENSOR**
PROTECTION DEVICE WITH A PRESSURE-SENSITIVE SENSOR FOR MONITORING AN INDUSTRIAL PLANT
DISPOSITIF DE PROTECTION PERMETTANT DE SURVEILLER UNE INSTALLATION TECHNIQUE AU MOYEN D'UN CAPTEUR SENSIBLE À LA PRESSION

(30) Priorität: 03.08.2016 DE 102016114384
(43) Veröffentlichungstag der Anmeldung: 12.06.2019
(73) Patentinhaber: Pilz GmbH & Co. KG, 73760 Ostfildern (DE)
(72) Erfinder: HART, Fabian, 73760 Ostfildern (DE); IBROCEVIC, Onedin, 73760 Ostfildern (DE); KUCZERA, Matthias, 73760 Ostfildern (DE); SCHWEIKER, Matthias, 73760 Ostfildern (DE); NEUSCHWANDER, Bernd, 73760 Ostfildern (DE); TEKDAL, Fabian, 73760 Ostfildern (DE); CHERAY, Philippe, 73760 Ostfildern (DE)
(74) Vertreter: Witte, Weller & Partner Patentanwälte mbB
(86) Internationale Anmeldenummer: PCT/EP2017/069699
(87) Internationale Veröffentlichungsnummer: WO 2018/024838

(56) Entgegenhaltungen:
- DE-A1- 10 303 409
- DE-T2- 3 887 757
- DE-U1- 20 014 200
- US-A- 4 441 097
- US-A- 4 839 512

## Beschreibung

Die vorliegende Erfindung betrifft eine Schutzeinrichtung zur Überwachung einer technischen Anlage mit einem druckempfindlichen Sensor, der eine Vielzahl von ersten Elektroden und eine Vielzahl von zweiten Elektroden aufweist, wobei jede erste Elektrode jede zweite Elektrode in einem zugehörigen Kopplungsort überlappt und wobei jede erste Elektrode in dem zugehörigen Kopplungsort durch ein druckempfindliches Material von der zugehörigen zweiten Elektrode beabstandet ist, sodass sich bei Einwirken einer Kraft an dem Kopplungsort ein elektrischer Widerstand zwischen der zughörigen ersten und der zugehörigen zweiten Elektrode verändert. Die Schutzeinrichtung weist eine Messelektronik auf, die mit der Vielzahl von ersten Elektroden und der Vielzahl von zweiten Elektroden gekoppelt ist und dazu ausgebildet ist, nacheinander den elektrischen Widerstand an den zugehörigen Kopplungsorten zu bestimmen. Eine Auswerteeinheit stellt in Abhängigkeit der gemessenen elektrischen Widerstände ein Ausgangssignal bereit.

Eine solche Schutzeinrichtung ist beispielsweise aus der EP 2 528 234 B1 bekannt.

Durch Fortschritte in der Signalerfassung und primärelektronischen Signalverarbeitung hat sich der Grad der Automatisierung von Fertigungsprozessen über die Jahre kontinuierlich erhöht. Dennoch sind und bleiben Eingriffe durch den Menschen wesentlicher Bestandteil eines Fertigungsprozesses, sodass sich die Entwicklung in den letzten Jahren vermehrt auf eine Optimierung der Zusammenarbeit zwischen Mensch und Maschine konzentriert. Insbesondere darf bei dieser Zusammenarbeit keine Gefahr für den Menschen ausgehen. Eine Maschine muss daher in die Lage versetzt werden, in ihrem Wirkungsbereich ihre Umwelt wahrzunehmen und zu erkennen, ob sich ein Gegenstand oder eine Person in unmittelbarer Nähe befindet. Neben einer umfangreichen Sensorik, mit welcher die Maschine ihre Umgebung wahrnimmt, bedarf es hierzu auch einer fehlerfreien und sicheren Auswertung der erfassten Signale, um ein sicheres Handin-Hand-Arbeiten von Mensch und Maschine zu ermöglichen.

Ein Sensor, mit dem der Zugang zu einer Maschine oder eine Berührung mit der Maschine erkannt werden kann, ist beispielsweise in der eingangs genannten EP 2 528 234 B1 offenbart. EP 2 528 234 B1 zeigt einen großflächigen, taktilen Sensor, der durch Zusammenschalten einer Vielzahl von einzelnen Sensorzellen realisiert ist, die bei mechanischer Belastung in definierter Weise ihre elektrische Eigenschaft verändern. Die Sensorzellen sind über in Spalten und Reihen angeordnete Elektroden einzeln kontaktierbar, sodass aus einer Messung der elektrischen Eigenschaften der einzelnen Zellen eine Druckverteilung über die gesamte Fläche bestimmt werden kann. Der Sensor kann als Trittmatte in einem Zugangsbereich zu einer Maschine verwendet werden oder aber auf der Oberfläche einer Maschine angeordnet sein, um als künstliche Haut Zusammenstöße zwischen Mensch und Maschine oder einem Gegenstand zu erkennen. DE 38 87 757 offenbart einen dünnen flexiblen Sensor zur Messung von entgegengesetzten Kräften an einer Vielzahl von Orten, bestehend aus einer Vielzahl von flexiblen, im allgemeinen parallelen Elektroden, getragen von einer dünnen flexiblen Stützschicht, und einen Satz angesteuerter Elektroden.

Für derartige druckempfindliche Schutzeinrichtungen sind die allgemeinen Grundsätze und Anforderungen an die sichere Gestaltung und deren Überprüfung in der EN ISO 13856-1 festgelegt. Insbesondere sind in der Norm die Mindestsicherheitsanforderungen in Bezug auf die Leistungsfähigkeit, Kennzeichnung und Dokumentation angegeben.

Je mehr Sensorzellen zu einem Sensor zusammengeschaltet werden, umso höher ist die lokale Auflösung des Sensors, allerdings ist auch der Aufwand der Signalauswertung entsprechend größer. Üblicherweise erfolgt die Auswertung einer größeren Anzahl an Sensorzellen daher nicht zeitgleich und parallel, sondern sequentiell, d.h., die einzelnen Sensorzellen werden kontinuierlich nacheinander durch die Auswerteeinheit abgefragt, um deren jeweiligen Zustand zu bestimmen. Je mehr Sensorzellen somit abgefragt werden müssen, umso länger dauert es, den gesamten Sensor abzufragen. Es ist daher wünschenswert, die Dauer einer Messung einer einzelnen Sensorzelle möglichst zu minimieren.

Bei einem matrixartig angeordneten Sensor, bei dem jede Elektrode jeweils mit mehreren Sensorzellen gekoppelt ist, kann es zudem zu Fehlerstrompfaden kommen, wenn mehrere Zellen gleichzeitig betätigt werden. Dies kann dazu führen, dass auch Zellen, die nicht belastet sind, als betätigt erkannt werden. Mit anderen Worten kann es vorkommen, dass beim gleichzeitigen Betätigen mehrerer Zellen eine Berührung an einem Ort registriert wird, obwohl an diesem Ort die zugehörige Sensorzelle nicht betätigt worden ist. Dieser Effekt, der auch als "Ghosting" bezeichnet wird, führt dazu, dass Sensoren der eingangs genannten Art nur eingeschränkt für sicherheitskritische Anwendungen eingesetzt werden können, da nicht fehlerfrei bestimmt werden kann, ob eine Belastung an einem Ort auf eine tatsächliche Belastung zurückgeht oder durch "Ghosting" hervorgerufen worden ist. Insbesondere wenn unterschiedliche Maßnahmen in Abhängigkeit des Belastungsorts ausgeführt werden sollen, ist "Ghosting" problematisch.
DE 103 03 409 A1 zeigt einen druckempfindlichen Sensor mit einer Widerstandsmatrix sowie eine Messschaltung, die das Auftreten von störenden Einflüssen während der Messung eines Widerstandselements der Widerstandsmatrix vermindert.
DE 200 14 200 U1, DE 38 87 757 T2, US 4 441 097 A und US 4 839 512 A zeigen jeweils weiteren Stand der Technik.

Vor diesem Hintergrund ist es eine Aufgabe, eine Schutzeinrichtung der eingangs genannten Art anzugeben, die eine schnelle Auswertung ermöglicht und Defekte hervorgerufen durch "Ghosting" verhindert. Insbesondere ist eine Schutzeinrichtung anzugeben, bei der jede Zelle fehlersicher auswertbar ist, um eine fehlersichere Ortsauflösung zu ermöglichen.

Gelöst wird diese Aufgabe durch eine Schutzeinrichtung gemäß Anspruch 1.

Ferner wird die Aufgabe gelöst durch ein Verfahren gemäß Anspruch 13.

Es ist somit eine Idee der vorliegenden Erfindung, eine angepasste Messelektronik bereitzustellen, die während der Messung einer einzelnen Zelle die übrigen Zellen so verschaltet, dass diese die Messung der einzelnen Zellen nicht beeinflussen können. Dies wird dadurch erreicht, dass bei der Messung einer Zelle über die erste zugehörige Elektrode und die zweite zugehörige Elektrode, die übrigen Elektroden mit einem definierten Potential belegt werden.

Als definiertes Potential wird hier ein zum allgemeinen Masseanschluss verschiedenes Potential bezeichnet, welches beispielsweise dem positiven Potential einer Versorgungsspannung des Sensors entspricht.

Das definierte Potential wird so gewählt, dass keine Fehlerströme von der gemessenen Zelle durch die mit dem definierten Potential belegten Zellen fließen kann. Bei einem matrixartigen Sensor bedeutet dies, dass sowohl die Elektroden als auch der Spalten, die an der Messung einer Zelle nicht beteiligt sind, mit dem definierten Potential belegt werden, indem sie während der Messung mit einem entsprechenden Anschluss verschaltet werden. Indem durch die Messelektronik Fehlerstrompfade durch die an der Messung nicht beteiligten Zellen ausgeschlossen werden können, kann "Ghosting" zuverlässig und auf einfache Weise vermieden werden.

Gleichzeitig verringert das Ausblenden der übrigen Zellen vorteilhaft die Dauer einer einzelnen Messung einer Sensorzelle. So kann eine Zelle in einem Ersatzschaltbild als Widerstand parallel zu einer Kapazität veranschaulicht werden, wobei die Ladezeit maßgeblich durch die Zeit zum Aufladen der Kapazität bestimmt wird. Beeinflussen die Kapazitäten benachbarter Zellen die Messung nicht mehr, kann eine Zelle schneller geladen und ausgelesen werden. Somit kann das Auslesen des gesamten Sensors beschleunigt werden. Vorteilhafterweise kann aufgrund der geringeren Gesamtkapazität der Sensor mit einer geringeren Versorgungsspannung betrieben werden, wodurch sich gleichzeitig vorteilhaft die Leistungsaufnahme insgesamt verringert.

Die oben genannte Aufgabe ist somit vollständig gelöst.

In einer vorteilhaften Ausgestaltung weist die Messelektronik ein erstes Selektionselement auf, das dazu ausgebildet ist, für die Bestimmung des elektrischen Widerstands die zugehörige erste Elektrode mit einem Anschluss zum Aufnehmen eines Messpotentials zu verbinden und die zugehörige zweite Elektrode mit einem Masseanschluss zu verbinden. Das erste Selektionselement ermöglicht es, die Elektroden, die für die Messung einer einzelnen Zelle benötigt werden, mit einem Messpotential und einem Masseanschluss zu verbinden. Gleichzeitig verbindet das erste Selektionselement die übrigen Elektroden mit einem definierten Potential, welches nicht einem Masseanschluss entspricht.

Bei dem ersten Selektionselement handelt es sich vorzugsweise um steuerbare Schaltelemente, mit denen die bevorzugte Beschaltung realisiert werden kann. Das Selektionselement kann dabei aus einer Vielzahl von einzelnen Schaltelementen gebildet werden, die von einer Steuereinheit betätigt werden. Durch die Verwendung eines Selektionselements lässt sich die erfindungsgemäße Beschaltung besonders einfach realisieren und automatisieren.

In einer weiteren vorteilhaften Ausgestaltung ist der Anschluss zum Aufnehmen des definierten Potentials mit dem Anschluss zum Aufnehmen des Messpotentials gekoppelt, sodass das definierte Potential betragsmäßig dem Messpotential entspricht. Indem das definierte Potential und das Messpotential betragsmäßig gleich groß sind, kann eine einzelne Zelle, welche mit dem Messpotential und Masse geschaltet wird, besonders gut von den übrigen Zellen isoliert werden. Aufgrund des gleichen Potentials an den übrigen Elektroden können keine Fehlerströme bei der Messung abfließen, welche die Messung einer einzelnen Zelle verfälschen könnten. Betragsmäßig gleich bedeutet in diesem Zusammenhang, dass die Potentiale der Höhe nach gleich sind, jedoch nicht zwangsläufig, dass das Messpotential mit dem definierten Potential unmittelbar verbunden ist.

In einer weiteren vorteilhaften Ausgestaltung weist die Messelektronik einen Impedanzwandler auf, der eingangsseitig mit dem Anschluss zum Aufnehmen eines Messpotentials verbunden ist und ausgangsseitig mit dem Anschluss zum Aufnehmen des definierten Potentials. Durch die Impedanzwandler werden das definierte Potential und das Messpotential voneinander getrennt, sodass sich die Potentiale nicht gegenseitig störend beeinflussen. Vorzugsweise hat der Impedanzwandler eingangsseitig einen hohen Eingangswiderstand und ausgangsseitig einen vernachlässigbaren kleinen Ausgangswiderstand.

In einer weiteren vorteilhaften Ausgestaltung ist der Impedanzwandler ein Operationsverstärker, der einen invertierenden Eingang, einen nicht-invertierenden Eingang und einen Ausgang aufweist, wobei der Ausgang auf den invertierenden Eingang zurückgekoppelt ist. Ein Operationsverstärker ist besonders gut als Impedanzwandler geeignet, da er für die vorliegende Anwendung nahezu ideale Bedingungen schafft. Insbesondere ist der Eingangswiderstand nahezu unendlich und der Ausgangswiderstand ungefähr Null. Das definierte Potential folgt somit dem Messpotential betragsmäßig, ohne es jedoch selbst zu beeinflussen.

Besonders vorteilhaft wird insgesamt nur ein einzelner Operationsverstärker in der Messelektronik benötigt, um das definierte Potential und das Messpotential für die Messung aller Zellen zu trennen. So kann die Messelektronik besonders kostengünstig realisiert werden.

In einer weiteren vorteilhaften Ausgestaltung weist die Messelektronik einen ersten Analog-Digital-Konverter auf und das erste Selektionselement ist dazu ausgebildet, die zugehörige erste Elektrode mit dem Analog-Digital-Konverter zu verbinden. Indem das erste Selektionselement die zugehörige erste Elektrode mit einem Messpotential und einem ersten Analog-Digital-Konverter verbindet, während gleichzeitig die zugehörige zweite Elektrode mit einem Masseanschluss verbunden ist, kann besonders einfach der Widerstand einer einzelnen Zelle durch eine Spannungsmessung bestimmt werden.

Vorzugweise ist zwischen dem Messpotential und dem Analog-Digital-Konverter ein Vorwiderstand angeordnet, sodass ein Spannungsteiler aus dem Vorwiderstand und dem zu bestimmenden Widerstand der Zelle gebildet wird. Über den Spannungsteiler kann besonders leicht und präzise der Widerstand der Zelle durch eine Spannungsmessung bestimmt werden.

In einer weiteren vorteilhaften Ausgestaltung weist die Messelektronik eine Testeinrichtung mit einem zweiten Selektionselement, einem Widerstand und einem zweiten Analog-Digital-Konverter auf, um Selbsttests durchführen zu können. Durch die Selbsttests können Fehler im normalen Betrieb des Sensors aufgedeckt werden. Das zweite Selektionselement kann dabei die ersten und zweiten Elektroden unabhängig vom ersten Selektionselement einzeln ansprechen, sodass über den zweiten Analog-Digital-Konverter und einen Mindestwiderstand Testmessungen vorgenommen können werden, bei denen die Widerstände des Sensors ausgeblendet sind. Die Testschaltung umfasst dann nur die für eine Messung benötigten Messkomponenten. So können vorteilhaft die einzelnen Messkomponenten auf ihre Funktionsfähigkeit hin überprüft werden, wodurch sich die Fehlersicherheit weiter vorteilhaft erhöht.

In einer weiteren vorteilhaften Ausgestaltung ist das zweite Selektionselement mit der Vielzahl erster Elektroden und der Vielzahl zweiter Elektroden gekoppelt und dazu ausgebildet, nacheinander jeweils eine Elektrode der Vielzahl erster Elektroden und zweiter Elektroden parallel zu dem Widerstand mit dem zweiten Analog-Digital-Konverter zu verbinden. Durch die Testeinrichtung kann bei einem matrixartigen Sensor ein Reihen-Spalten-Test durchgeführt werden, bei dem Querschlüsse zwischen der Vielzahl erster Elektroden und der Vielzahl zweiter Elektroden detektiert werden können.

In einer besonders bevorzugten Ausgestaltung ist die Testeinrichtung dazu eingerichtet, das erste und zweite Selektionselement zyklisch auf jeweils die gleiche Elektrode der Vielzahl der ersten und zweiten Elektroden zu schalten, um einen ersten Schalttest durchzuführen. Mit dem ersten Schalttest kann das erste Selektionselement vorteilhaft auf korrektes Schalten hin überprüft werden.

In einer weiteren vorteilhaften Ausgestaltung ist die Testeinrichtung dazu eingerichtet, das erste und zweite Selektionselement zyklisch auf die Vielzahl von ersten und zweiten Elektroden zu schalten, sodass zwischen dem ersten und dem zweiten Selektionselement jeder Widerstand eines Kopplungsorts anliegt, um einen zweiten Schalttest durchzuführen. Mit dem zweiten Schalttest können vorteilhaft Querschlüsse zwischen den Elektroden detektiert werden.

Die Auswerteeinheit ist dazu ausgebildet, die gemessenen Widerstände anhand einer gemessenen Spannung zu bestimmen und für jeden Kopplungsort ein erstes, zweites oder drittes Ausgangssignal in Abhängigkeit der gemessenen Spannung bereitzustellen. Die Auswerteeinheit kann zwischen drei Ausgangssignalen unterscheiden, die in Abhängigkeit der gemessenen Widerstände bereitgestellt werden. Für jede Zelle wird eines der drei Ausgangssignale erzeugt. Die Messungen der einzelnen Zellen können aggregiert werden, sodass ein Ausgangssignal stellvertretend für den gesamten Sensor ausgegeben wird.

In einer weiteren vorteilhaften Ausgestaltung entspricht das erste Ausgangssignal einem Fehlersignal, das zweite Ausgangssignal einem Signal, welches einen betätigten Zustand am Kopplungsort anzeigt, und das dritte Ausgangssignal einem Signal, welches einen nicht betätigten Zustand am Kopplungsort anzeigt. Die Unterscheidung zwischen einem Fehlersignal, welches einen allgemeinen Fehlerzustand angibt, einem Signal, welches eine betätigte Zelle repräsentiert und einem Signal, welches eine unbetätigte Zelle signalisiert, ermöglicht eine differenzierte Auswertung der einzelnen Zellen und eine fehlersichere Ortsauflösung.

Die Auswerteeinheit ist dazu ausgebildet, das erste Ausgangssignal auszugeben, wenn die gemessene Spannung einen ersten Schwellwert unterschreitet oder einen zweiten Schwellwert überschreitet, das zweite Signal auszugeben, wenn die gemessene Spannung den ersten Schwellwert überschreitet und einen dritten Schwellwert, welcher zwischen dem ersten und dem zweiten Schwellwert liegt, unterschreitet, und das dritte Ausgangssignal auszugeben, wenn die gemessene Spannung den dritten Schwellwert überschreitet und den zweiten Schwellwert unterschreitet. Die Art des Ausgangssignals ergibt sich aus der gemessenen Spannung, die an dem Widerstand der einzelnen Zelle abfällt. Der erste Schwellwert entspricht einer unteren Grenze und der zweite Schwellwert entspricht einer oberen Grenze, innerhalb derer sich ein gemessener Spannungspegel für eine ordnungsgemäße Messung befinden muss. Ist ein gemessener Spannungspegel unterhalb der unteren Grenze, wird eine Fehlerreaktion ausgelöst, da ein Querschluss einer Elektrode auf Masse angenommen wird, beispielsweise aufgrund von Flüssigkeit, die in den Sensor eingedrungen ist. Liegt ein gemessener Spannungspegel oberhalb der oberen Grenze, geht das System ebenfalls in einen Fehlerzustand über. Gründe hierfür können unter anderem Alterung, Korrosion oder mechanischer Verschleiß einzelner Sensorzellen sowie Drift sein. Ebenso können eine schlechte Verbindung oder eine Trennung der Elektrode sowie ein Stuck-at-High-Fehler einer Elektrode vorliegen.

In einer weiteren vorteilhaften Ausgestaltung ist die Auswerteeinheit mehrkanalig redundant ausgebildet. Die redundante Ausbildung erhöht die Fehlersicherheit der Schutzeinrichtung. Vorzugsweise wird die Auswerteeinheit aus zwei funktionsgleichen Kontrollern zusammengesetzt, die miteinander kommunizieren können und sich gegenseitig überwachen können. Besonders vorteilhaft sind die funktionsgleichen Controller von verschiedenen Herstellern, um die Diversität zu erhöhen.

Es versteht sich, dass die vorstehend genannten und die nachstehend noch zu erläuternden Merkmale nicht nur in der jeweils angegebenen Kombination, sondern auch in anderen Kombinationen oder in Alleinstellung verwendbar sind, ohne den Rahmen der vorliegenden Erfindung zu verlassen.

Ausführungsbeispiele der Erfindung sind in der Zeichnung dargestellt und werden in der nachfolgenden Beschreibung näher erläutert. Es zeigen:
- Fig. 1: eine schematische Darstellung möglicher Anwendungsgebiete von Ausführungsbeispielen der neuen Schutzeinrichtung,
- Fig. 2: ein Ausführungsbeispiel der neuen Schutzeinrichtung in einer Draufsicht,
- Fig. 3: eine vereinfachte schematische Darstellung des Aufbaus eines Ausführungsbeispiels eines neuen Sensors,
- Fig. 4: ein Ersatzschaltbild eines Ausführungsbeispiels des neuen Sensors,
- Fig. 5: eine vereinfachte schematische Darstellung einer Messschaltung eines Ausführungsbeispiels des neuen Sensors,
- Fig. 6: ein erstes Ausführungsbeispiel einer neuen Schutzeinrichtung,
- Fig. 7: ein zweites Ausführungsbeispiel einer neuen Schutzeinrichtung,
- Fig. 8: ein vereinfachtes Ersatzschaltbild einer Messschaltung gemäß der Ausführungsbeispiele nach Fig. 6 und 7,
- Fig. 9: eine schematische Darstellung des Zusammenhangs zwischen einer gemessenen Spannung und dem Ausgangssignal, und
- Fig. 10: ein Ersatzschaltbild der neuen Testeinrichtung gemäß der Ausführungsbeispiele aus Fig. 6 und 7.

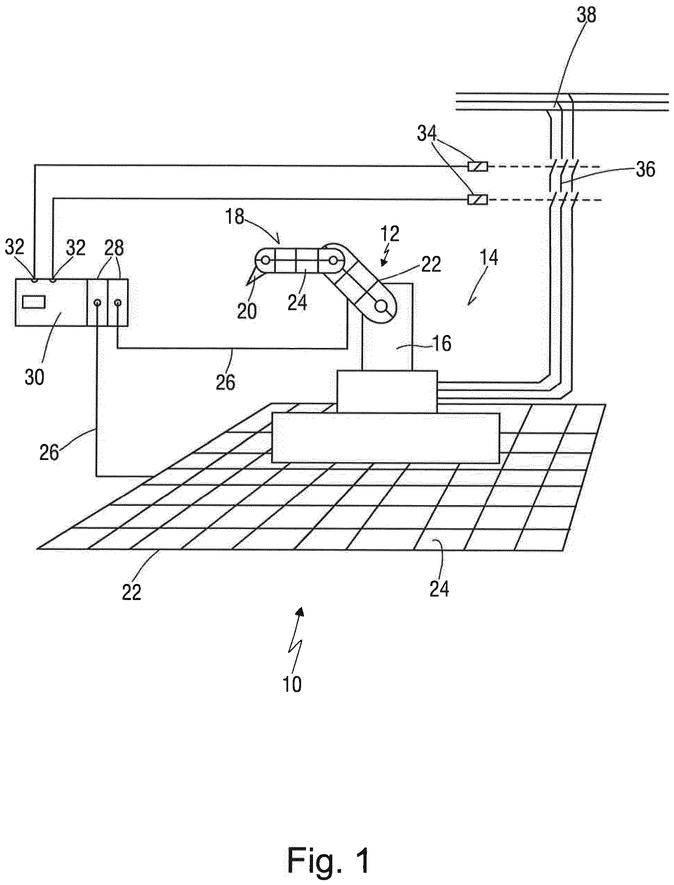

Fig. 1 zeigt eine schematische Darstellung möglicher Anwendungsgebiete von Ausführungsbeispielen der neuen Schutzeinrichtung.

In der Fig. 1 sind zwei Ausführungsbeispiele der neuen Schutzeinrichtung mit den Bezugsziffern 10 und 12 bezeichnet. Beide Schutzeinrichtungen überwachen eine technische Anlage 14, die hier als automatisiert arbeitender Roboter 16 angedeutet ist. Bei dem Roboter 16 kann es sich beispielsweise um einen Schneid- oder Schweißroboter in einer Fertigungs- oder Montagelinie handeln.

In dem in Fig. 1 gezeigten Ausführungsbeispiel weist der zu überwachende Roboter 16 einen frei beweglichen Roboterarm 18 auf, an dessen Enden sich ein Werkzeug 20 befindet. Der Dreh- und Schwenkbereich des Roboterarms 18 definiert einen Wirkungsbereich des Roboters 16, der gleichzeitig ein Gefahrenbereich des Roboters 16 darstellt. Ein Eintreten in den Gefahrenbereich - sowohl unberechtigtes als auch berechtigtes - muss erkannt werden, sodass der Roboter 16 in einen für Personen oder Gegenstände ungefährlichen Zustand überführt werden kann. Die Erkennung erfolgt hier durch die Schutzeinrichtungen 10 und 12, die mit einem Sicherheitssystem 30 gekoppelt sind.

Das Sicherheitssystem 30 kann eine Ausgangsschalteinrichtung im Sinne der EN ISO 13856-1 sein, beispielsweise ein einfaches Sicherheitsschaltgerät, eine konfigurierbare Sicherheitssteuerung oder aber eine programmierbare Steuereinheit. Das Sicherheitssystem 30 ist dazu ausgebildet, die technische Anlage 14 in einen für Personen ungefährlichen Zustand zu überführen, beispielsweise indem die technische Anlage 14 stromlos geschaltet wird.

Das erste Ausführungsbeispiel der neuen Schutzeinrichtung 10 ist hier eine Trittmatte, die am Boden im Bereich um die technische Anlage 14 angeordnet ist. Das zweite Ausführungsbeispiel der neuen Schutzeinrichtung 12 ist eine Verkleidung des Roboterarms 18, die hier als berührungssensitive "Haut" des Roboters 16 wirkt. Beide Schutzeinrichtungen 10, 12 weisen einen druckempfindlichen Sensor 22 auf, der aus einer Vielzahl von einzelnen Sensorzellen 24 gebildet ist. Wie insbesondere durch den zweiten Anwendungsfall angedeutet ist der Sensor 22 aus flexiblen Material, sodass er an verschiedene Formen, wie hier bspw. der Form des Roboterarms, angepasst werden kann.

Wie im Folgenden noch näher erläutert wird, ist der Sensor 22 dazu ausgebildet, eine Druckveränderung in einer der Sensorzellen 24 zu detektieren und ein entsprechendes Ausgangssignal zu erzeugen. Das Ausgangssignal wird über die Leitungen 26 an Eingangsmodule 28 des Sicherheitssystems 30 übertragen, welches die Signale auswertet und in Abhängigkeit davon eine Reaktion auslöst. Das Sicherheitssystem 30 ist in diesem Ausführungsbeispiel für diesen Zweck über Ausgänge 32 mit Schützen 34 verbunden, deren Arbeitskontakte 36 in einer Stromversorgung 38 des Roboters 16 angeordnet sind.

Wird eine Sensorzelle 24 der Trittmatte 10 im Gefahrenbereich der technischen Anlage 14 belastet oder wird durch die Roboterhaut 12 eine Berührung des Sensors 22 mit einem Gegenstand oder einer Person detektiert, schaltet das Sicherheitssystem 30 die Ausgänge 32 ab, sodass die Schütze 34 abfallen und die technische Anlage 14 durch Öffnen der Arbeitskontakte 36 stromlos geschaltet wird. Durch das Stromlosschalten wird die technische Anlage 14 in einen für Personen oder Gegenstände sicheren Zustand überführt.

Es versteht sich, dass das Stromlosschalten der technischen Anlage 14 nur eine Möglichkeit darstellt, die technische Anlage 14 in einen sicheren Zustand zu überführen. Alternativ oder ergänzend kann in einem anderen Ausführungsbeispiel das Sicherheitssystem 30 auch steuernd in den Bewegungsablauf des Roboters 16 eingreifen, um einen sicheren Zustand herbeizuführen, beispielsweise indem der Roboter 16 den Roboterarm 18 einzieht. Ebenso ist es denkbar, dass die Ausgangssignale der Sensoren 22 der ersten Schutzeinrichtung 10 und der zweiten Schutzeinrichtung 12 oder die Ausgangssignale weiterer Schutzeinrichtungen kombiniert betrachtet werden und das Sicherheitssystem 30 aus der Zusammenschau eine Entscheidung über die Ansteuerung des Roboters 16 trifft. Weitere Schutzeinrichtungen können beispielsweise berührungslos wirkende Schutzeinrichtungen (BWS), wie Lichtschranken oder Lichtgitter, oder aber ein sicheres Kamerasystem sein.

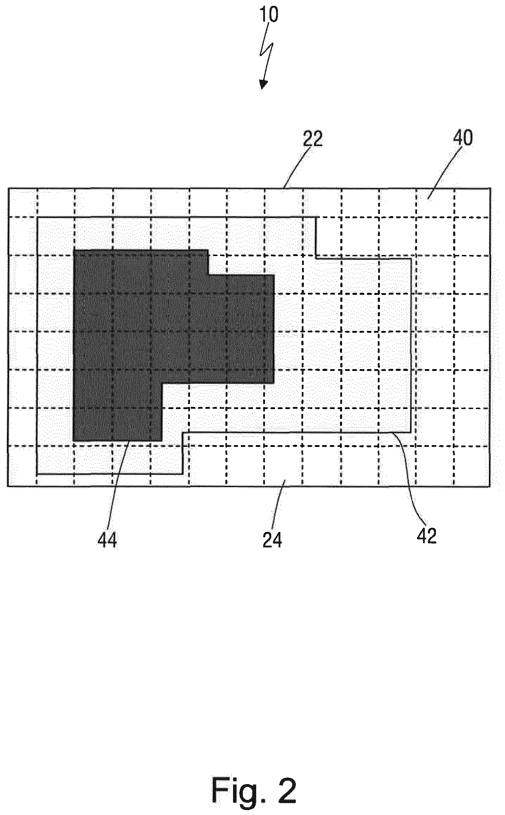

Fig. 2 zeigt ein Ausführungsbeispiel der neuen Schutzeinrichtung 10 in einer Draufsicht.

Der Sensor 22 ist hier matrixartig in eine Vielzahl von Sensorzellen 24 unterteilt. Darüber hinaus ist der Sensor 22 in verschiedene Bereiche unterteilt, denen verschiedene Sensorzellen 24 zugeordnet sind. Ein erster Bereich 40 (hier ohne Füllung dargestellt) bildet den Randbereich des Sensors 22. Eine Belastung der Sensorzellen 24 in diesem ersten Bereich führt zu keiner Reaktion der Schutzeinrichtung 10. Ein zweiter Bereich 42 (hellgrau dargestellt) bildet einen Warnbereich. Bei einer Belastung einer Sensorzelle 24, die dem Warnbereich zugeordnet ist, löst die Schutzeinrichtung 10 ein Warnsignal aus, welches beispielsweise zum Aufleuchten einer Warnanzeige führen kann. Der dritte Bereich 44 (dunkelgrau dargestellt) markiert ein Schutzfeld. Sobald eine Sensorzelle 24, die dem Schutzfeld zugeordnet ist, belastet wird, wird eine Sicherheitsfunktion ausgelöst, die dazu führt, dass die zu überwachende technische Anlage 14 in einen sicheren Zustand überführt wird. Es versteht sich, dass für eine solche funktionale Unterteilung des Sensors 22 eine Belastung jeder Sensorzelle 24 zuverlässig und fehlersicher erkannt werden muss. Das heißt, der Sensor 22 muss eine fehlersichere Ortsauflösung gewährleisten. Die Zuordnung einer Zelle zu einem Bereich erfolgt nach der Priorität der zugehörigen Ausgangssignale. Umfasst eine Zelle zwei Bereiche, so wird der Zelle jeweils die höhere Stufe zugeordnet.

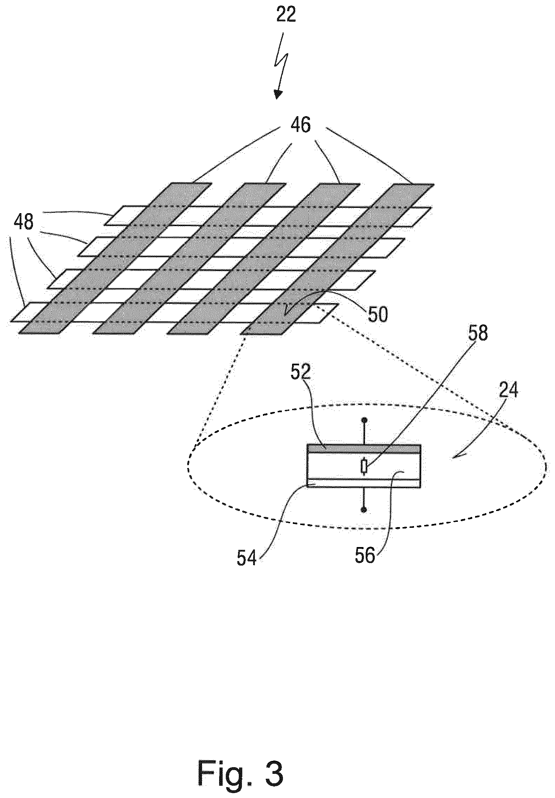

Fig. 3 zeigt in einer vereinfachten schematischen Darstellung den Aufbau eines Ausführungsbeispiels eines neuen Sensors.

Der Sensor 22 weist eine Vielzahl von ersten Elektroden 46 und eine Vielzahl von zweiten Elektroden 48 auf, die sich gegenseitig überlappen. Jede erste Elektrode überlappt jede zweite Elektrode in einem zugehörigen Kopplungsort 50. An jedem Kopplungsort 50 bildet sich eine Sensorzelle 24 aus, wie sie hier schematisch in der Vergrößerung angedeutet ist. Eine Sensorzelle 24 umfasst somit eine zugehörige erste Elektrode 52 und eine zugehörige zweite Elektrode 54 sowie ein druckempfindliches Material 56, welches die beiden Elektroden 52, 54 voneinander beabstandet. In einem Ausführungsbeispiel ist das druckempfindliche Material 56 so ausgebildet, dass es beim Einwirken einer Kraft seinen spezifischen Widerstand ändert, sodass sich ein elektrischer Widerstand 58 zwischen der zugehörigen ersten Elektrode 52 und der zugehörigen zweiten Elektrode 54 ändert, wenn die Zelle mechanisch belastet wird. Alternativ können die ersten und zweiten Elektroden 46, 48 und das druckempfindliche Material 56 auch so ausgebildet sein, dass sie bei einer Krafteinwirkung zusammenwirken, sodass sich der elektrische Widerstand 58 zwischen der zugehörigen ersten Elektrode 52 und der zugehörigen zweiten Elektrode 54 ändert.

In einem bevorzugten Ausführungsbeispiel ist das druckempfindliche Material des Sensors aus einem Polymeren gefertigt, welches mit leitfähigen Additiven durchsetzt ist. Gemessen an der Leitfähigkeit ist dieses Material zwischen Isolatoren und Leitern einzuordnen, wobei die Zuordnung von der jeweiligen Konzentration der leitfähigen Additive abhängig ist. Die leitfähigen Partikel sind meistens Ruß, metallische Partikel, metallbeschichtete Partikel oder Kohlenstofffasern. Die Leitfähigkeit des Materials beruht auf dem Prinzip der Perkolation. Dabei entstehen leitfähige Brücken, welche durch das gesamte Material hindurchreichen. Wird nun Druck auf das Material ausgeübt, verdichtet es sich und es bilden sich neue Brücken aus leitfähigen Partikeln. Um das Material als taktilen Sensor einzusetzen, wird eine matrixförmige Matte konzipiert, deren einzelne Zellen aus dem Polymermaterial gefertigt sind. Zur Widerstandsauswertung werden auf Ober- und Unterseite des druckempfindlichen Materials Elektroden in Form von leitfähigen Fäden angebracht, die in den Bereichen, in denen sie sich überlappen, die Sensorzellen ausbilden.

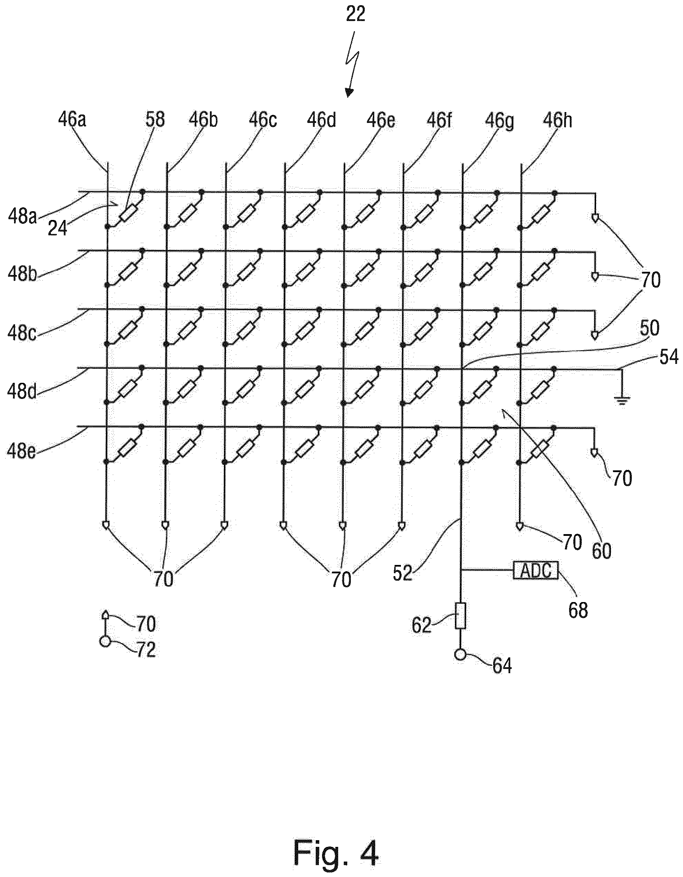

Fig. 4 zeigt ein Ersatzschaltbild eines Ausführungsbeispiels des neuen Sensors 22.

Die Vielzahl von ersten Elektroden 46 ist durch vertikal verlaufende Leiterbahnen 46a - 46h angedeutet. Die Vielzahl von zweiten Elektroden 48 ist durch horizontal verlaufende Leiterbahnen 48a-48e angedeutet. Die ersten Elektroden bilden somit die Spalten und die zweiten Elektroden die Reihen des matrixartigen Sensors 22. An den Schnittpunkten der Leiterbahnen (46a-46h, 48a-48e) befinden sich die Sensorzellen 24, die im Ersatzschaltbild durch ihren entsprechenden elektrischen Widerstand 58 angedeutet sind.

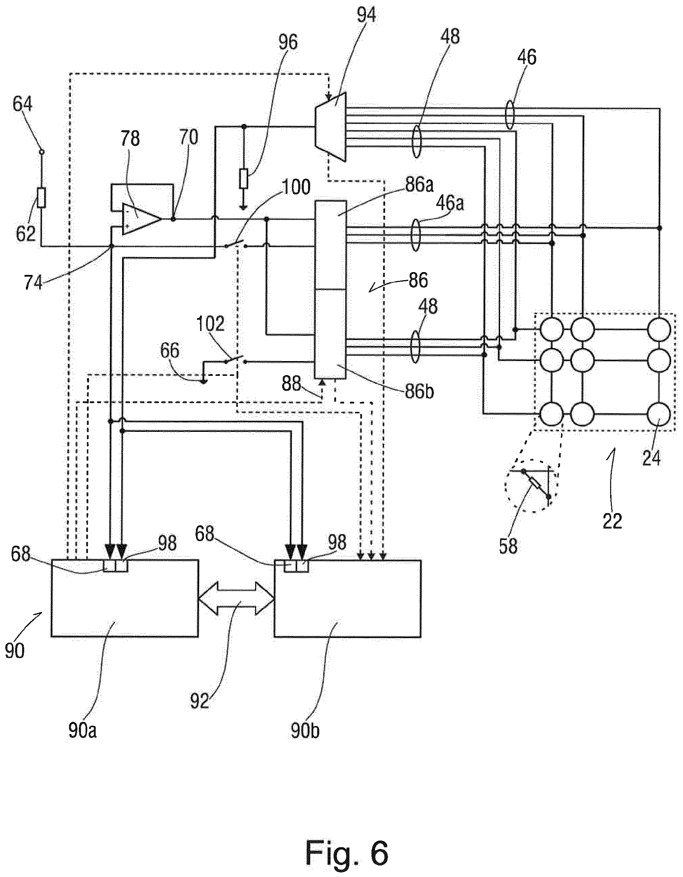

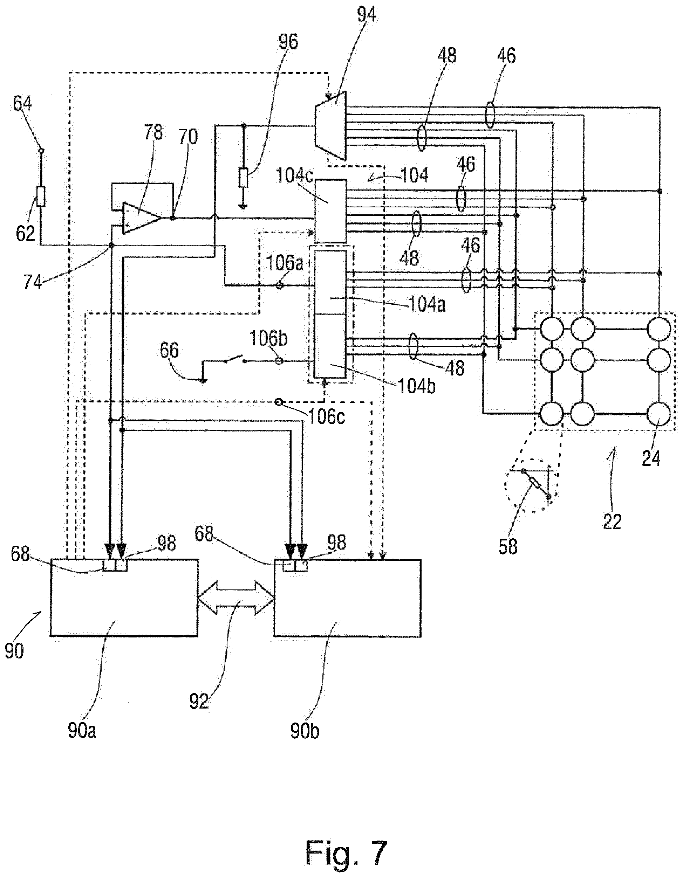

Für eine Messung des elektrischen Widerstands 58 einer Sensorzelle 24 können die ersten Elektroden 46a-46h und die zweiten Elektroden 48a-48e abwechselnd mit verschiedenen Potentialen belegt werden. Dies erfolgt über (hier nicht dargestellte) Schaltelemente, die im Detail mit Bezug zu den Fig. 6 und 7 näher erläutert werden.

Exemplarisch ist in Fig. 4 die Messung der Sensorzelle 60 angedeutet, welche sich am Kopplungsort 50 der zugehörigen ersten Elektrode 46g, 52 und der zugehörigen zweiten Elektrode 48d, 54 befindet. Für die Messung ist die zugehörige erste Elektrode 46g, 52 über einen Vorwiderstand 62 mit einem Anschluss zum Aufnehmen eines Messpotentials 64 verbunden. Gleichzeitig ist die zugehörige zweite Elektrode 48d, 54 mit einem Masseanschluss 66 verbunden. Der Vorwiderstand 62 und der elektrische Widerstand 58 der Sensorzelle 60 bilden einen Spannungsteiler, an dem mittels eines ersten Analog-Digital-Konverters 68 ein Spannungswert ermittelt werden kann. Aus dem gemessenen Spannungswert kann unmittelbar der elektrische Widerstand 58 der Sensorzelle 60 bestimmt werden und daraus weiter die mechanische Belastung der Sensorzelle 60.

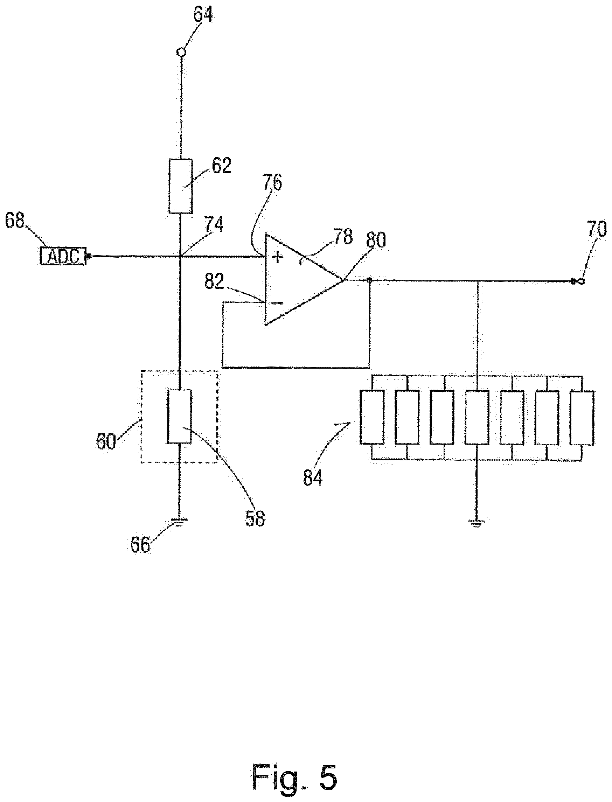

Erfindungsgemäß sind während der Messung die übrigen ersten Elektroden 46a-46f, 46h und die übrigen zweiten Elektroden 48a-48c, 48e, die nicht an der Messung der aktuellen Sensorzelle 60 beteiligt sind, mit einem definierten Potential 70 belegt, wie es hier über den gemeinsamen Anschluss zum Aufnehmen eines definierten Potentials 72 angedeutet ist. Das definierte Potential 70 entspricht dabei betragsmäßig dem Messpotential 74, wenngleich das definierte Potential 70 vorzugsweise nicht unmittelbar mit dem Messpotential 74 verbunden ist. Der Zusammenhang zwischen dem definierten Potential 70 und dem Messpotential 74 ist näher mit Bezug auf Fig. 5 erläutert.

Fig. 5 zeigt eine vereinfachte schematische Darstellung einer Messschaltung eines Ausführungsbeispiels des neuen Sensors. Gleiche Bezugszeichen bezeichnen gleiche Teile wie in Fig. 4.

Die Bestimmung des elektrischen Widerstands 58 der gemessenen Sensorzelle 60 erfolgt über eine Spannungsmessung am ersten Analog-Digital-Konverters 68. Vorzugsweise wird die am elektrischen Widerstand 58 abfallende Spannung über einen Spannungsteiler gemessen, um eine präzise Messung auch bei stark variierenden Widerständen 58 zu ermöglichen. Zwischen dem Anschluss zum Aufnehmen eines Messpotentials 64 und dem elektrischen Widerstand 58 der Sensorzelle 60 ist somit ein Vorwiderstand 62 angeordnet, sodass sich ein Messpotential 74 zwischen dem elektrischen Widerstand 58 der Sensorzelle 60 und dem Vorwiderstand 62 einstellt, welches vom ersten Analog-Digital-Konverter 68 aufgenommen und gemessen wird.

Das Messpotential 74 liegt darüber hinaus an einem nicht invertierenden Eingang 76 eines Operationsverstärkers 78 an. Der Ausgang 80 des Operationsverstärkers 78 ist an den invertierenden Eingang 82 des Operationsverstärkers 80 unmittelbar zurückgekoppelt, sodass der Operationsverstärker 78 als Impedanzwandler fungiert.

Am Ausgang 80 stellt sich das definierte Potential 70 ein, das betragsmäßig dem Messpotential 74 entspricht, jedoch von diesem durch den Impedanzwandler getrennt ist. Mit anderen Worten folgt das definierte Potential 70 dem Messpotential 74, beeinflusst dieses jedoch nicht. Es versteht sich, dass auch ein anderer Impedanzwandler anstelle des Operationsverstärkers 78 verwendet werden kann. Ein Operationsverstärker hat jedoch den Vorteil, dass er nahezu eine ideale Trennung ermöglicht, da der Eingangswiderstand an den Eingängen nahezu unendlich ist und ein Ausgangswiderstand an dem Ausgang ungefähr Null ist.

Das an das Messpotential 74 betragsmäßig gekoppelte definierte Potential 70 wird mit den übrigen Elektroden verbunden. Somit ist nur der elektrische Widerstand 58 der zu messenden Sensorzelle 60 mit dem Messpotential 74 und dem Masseanschluss 66 verbunden. Die übrigen elektrischen Widerstände 58 der gleichen Reihe, die mit der Bezugsziffer 84 angedeutet sind, sind einerseits mit dem Masseanschluss 66 und andererseits mit dem definierten Potential 70 verbunden. Die weiteren Widerstände der gleichen Spalte (hier nicht dargestellt) sind einerseits mit dem Messpotential 74 und andererseits mit dem definierten Potential 80 verbunden. Da das Messpotential 74 und das definierte Potential 70 betragsmäßig gleich sind, können keine Fehlerströme durch die Sensorzellen in derselben Reihe und Spalte fließen, sodass eine isolierte Messung der Sensorzelle 60 möglich ist.

Fig. 6 und Fig. 7 zeigen zwei bevorzugte Ausführungsbeispiele der neuen Schutzeinrichtung. In beiden Figuren bezeichnen gleiche Bezugsziffern gleiche Teile, sodass diese im Folgenden nur in Bezug auf eine Figur beschrieben werden.

Fig. 6 zeigt ein erstes Ausführungsbeispiel der neuen Schutzeinrichtung. Der druckempfindliche Sensor 22 ist hier mit neun Sensorzellen 24 angedeutet, die matrixartig in drei Spalten und drei Reihen angeordnet sind. Durch den unterschiedlichen Abstand der Reihen und Spalten wird hier angedeutet, dass der Sensor 22 auch eine größere Anzahl von Reihen und Spalten aufweisen kann. Ebenso müssen nicht zwangsläufig die Anzahl der Reihen und Spalten gleich groß sein.

Die Sensorzellen 24 einer Spalte sind je über eine erste Elektrode miteinander verbunden und die Sensorzellen 24 einer Reihe sind je über eine zweite Elektrode miteinander verbunden. Die ersten Elektroden der Spalten bilden somit eine Vielzahl von ersten Elektroden 46 und die zweiten Elektroden der Reihen bilden eine Vielzahl von zweiten Elektroden 48.

Die Vielzahl von ersten Elektroden 46 und die Vielzahl von zweiten Elektroden 48 sind mit einem ersten Selektionselement 86 verbunden. Das Selektionselement 86 ist hier durch zwei logische Einheiten 86a, 86b angedeutet. Die erste logische Einheit 86a ist eingangsseitig mit der Vielzahl erster Elektroden 46 verbunden und ausgangsseitig einerseits mit dem Messpotential 74 und andererseits mit dem definierten Potential 70 verbunden, welches über einen rückgekoppelten Operationsverstärker 78 mit dem Messpotential 74 gekoppelt ist. Die zweite logische Einheit 86b ist eingangsseitig mit der Vielzahl von zweiten Elektroden 48 und ausgangsseitig einerseits mit einem Masseanschluss 66 und andererseits mit dem definierten Potential 70 verbunden.

Das Selektionselement 86 ist dazu ausgebildet, die eingangsseitig anliegenden Elektroden 46, 48 wahlweise mit den ausgangsseitigen Anschlüssen zu verbinden. Die Vielzahl erster Elektroden 46 kann somit über die erste logische Einheit 86a selektiv mit dem definierten Potential 70 oder dem Messpotential 74 verbunden werden. Die Vielzahl von zweiten Elektroden 48 kann über die zweite logische Einheit 86b selektiv mit dem definierten Potential 70 oder dem Masseanschluss 66 verbunden werden.

Die erste und zweite Einheit 86a, 86b des Selektionselements 86 sind als "logisch" bezeichnet, da die hardwaremäßige Ausgestaltung auch mehrere Komponenten umfassen kann, die zusammengeschaltet die logische erste und zweite Einheit 86a, 86b bilden. Beispielsweise kann das erste Selektionselement 86 eine Vielzahl von in CMOS-Technik realisierten Schaltelementen umfassen, die mehrere unabhängige Schalter aufweisen. Ein Beispiel für ein solches Schaltelement ist das HDG788 von Analog Devices, welches vier unabhängige SPDT-(single pole, double throw)-Schalter umfasst. Mittels vier solcher Schaltelemente lässt sich ein Selektionselement 86 für eine 8x8-Matrix (64 Zellen) realisieren.

Angesteuert wird das erste Selektionselement 86 über einen Dateneingang 88, wobei vorzugsweise jeder Schalter einen eigenen logischen Eingang aufweist. Ein entsprechendes Ansteuersignal wird von einer Steuereinheit 90 bereitgestellt, die hier gleichzeitig auch die Auswerteeinheit ist. Die Steuereinheit 90 kann eine digitale oder analoge Schaltung, ein Mikrocontroller, ein FPGA, ein ASIC oder jede andere Verarbeitungseinheit sein.

In dem hier dargestellten bevorzugten Ausführungsbeispiel umfasst die Steuer-/Auswerteeinheit 90 zwei getrennte Mikrocontroller 90a, 90b, die über eine Kommunikationsschnittstelle 92, beispielsweise eine serielle UART-Schnittstelle, miteinander gekoppelt sind. Die Mikrocontroller 90a, 90b sind funktionsgleich, jedoch vorzugsweise nicht vom selben Typ oder vom selben Hersteller, um die Diversität zu erhöhen. Über die Kommunikationsschnittstelle 92 können die Mikrocontroller 90a, 90b miteinander kommunizieren und sich gegenseitig überwachen und kontrollieren. Eine solche Anordnung wird auch als redundant, mehrkanalig bezeichnet.

Die Steuer-/Auswerteeinheit 90 steuert das erste Selektionselement 86 so an, so jeder elektrische Widerstand 58 der Sensorzellen 24 des Sensors 22 in einem Zyklus ausgelesen werden kann. Darüber hinaus steuert die Steuer-/Auswerteeinheit 90 die im Folgenden noch näher erläuterte Testeinrichtung an, wie es hier durch die vom ersten Mikrocontroller ausgehenden gestrichelten Pfeile angedeutet ist. Der zweite Mikrocontroller 90b überwacht die Ansteuerung, indem die Ansteuersignale des ersten Mikrocontrollers 90a zusätzlich an die Eingänge des zweiten Mikrocontrollers 90b geführt werden. Dies ist hier durch die am zweiten Mikrocontroller 90b eingehenden gestrichelten Pfeile angedeutet.

Die Steuereinheit 90 fungiert in diesem Ausführungsbeispiel gleichzeitig als Auswerteeinheit und weist hierzu einen ersten Analog-Digital-Konverter 68 auf. Aufgrund der redundanten Auslegung der Steuereinheit 90 weist sowohl der erste Mikrocontroller 90a als auch der zweite Mikrocontroller 90b einen entsprechenden ersten Analog-Digital-Konverter 68 auf. Der erste Analog-Digital-Konverter 68 ist mit dem Messpotential 74 verbunden, der hier über einen Vorwiderstand 62 mit einem Anschluss zum Aufnehmen eines Messpotentials 64 verbunden ist. Bei dem Anschluss 64 kann es sich insbesondere um einen Versorgungsspannungsanschluss handeln.

Wie anhand der Fig. 5 im Einzelnen erläutert, steuert die Steuereinheit 90 alle Sensorzellen 24 in einem Zyklus an, sodass der elektrische Widerstand 58 einer jeden Sensorzelle 24 über den Spannungsteiler aus Vorwiderstand 62 und elektrischem Widerstand 58 durch die Messung des Messpotentials 74 am ersten Analog-Digital-Konverter 68 bestimmt werden kann. Gleichzeitig steuert die Steuereinheit 90 das erste Selektionselement 86 so an, dass die jeweils an der Messung nicht beteiligten Elektroden mit dem definierten Potential 70 belegt sind, um die Messung nicht zu beeinflussen. Wie aus der Fig. 6 entnehmbar ist, ist dabei nur ein Impedanzwandler 78 notwendig, um für alle Elektroden das definierte Potential 70 bereitzustellen.

Die Messelektronik des in Fig. 6 gezeigten Ausführungsbeispiels weist zudem eine Testeinrichtung auf, mittels derer sich einzelne Komponenten der Messelektronik auf ihre Funktionsfähigkeit hin überprüfen lassen. Die Testeinrichtung umfasst ein zweites Selektionselement 94, einen Widerstand 96 sowie einen zweiten Analog-Digital-Konverter 98. Der zweite Analog-Digital-Konverter 98 ist wie der erste Analog-Digital-Konverter 68 redundant in beiden Mikrocontrollern 90a und 90b enthalten. Darüber hinaus weist die Testeinrichtung in dem in Fig. 6 gezeigten bevorzugten Ausführungsbeispiel noch ein erstes und ein zweites Schaltelement 100, 102 auf.

Das zweite Selektionselement 94 ist eingangsseitig mit der Vielzahl von ersten Elektroden 46 und mit der Vielzahl von zweiten Elektroden 48 verbunden. Ausgangsseitig ist das zweite Selektionselement 94 einerseits mit dem zweiten Analog-Digital-Konverter 98 und andererseits gleichzeitig über den Widerstand 96 mit einem Masseanschluss 66 verbunden. Über das erste Schaltelement 100 kann die erste logische Einheit 86a vom Messpotential 74 getrennt werden und über das zweite Schaltelement 102 kann die zweite logische Einheit 86b vom Masseanschluss 66 getrennt werden. Das zweite Selektionselement 94 ist dazu ausgebildet, die Vielzahl erster und zweiter Elektroden 46, 48 nacheinander mit dem zweiten Analog-Digital-Konverter 98 zu verbinden, um die ordnungsgemäße Funktion des ersten Selektionselements 86 zu überprüfen. Für solch einen Test werden das erste Selektionselement 86 und das zweite Selektionselement 94 synchron auf dieselbe Elektrode geschaltet, sodass der elektrische Widerstand 58 einer Sensorzelle 24 überbrückt wird, sodass das erste und das zweite Selektionselement 86, 94 unmittelbar miteinander verbunden sind. Darüber hinaus sind die erste und die zweite logische Einheit 86a, 86b so eingestellt, dass sie die eingangsseitigen ersten Elektroden 46 mit dem Messpotential 74 verbinden und die eingangsseitig verbundenen zweiten Elektroden 48 mit dem Masseanschluss 66 verbinden.

Die Teststeuerung und -auswertung erfolgt ebenfalls durch die Steuer-/Auswerteeinheit 90, welche das erste und das zweite Selektionselement 86, 94 entsprechend ansteuert und mit dem zweiten Analog-Digital-Konverter 98 die sich jeweils einstellende Spannung misst und mit einem Erwartungswert vergleicht.

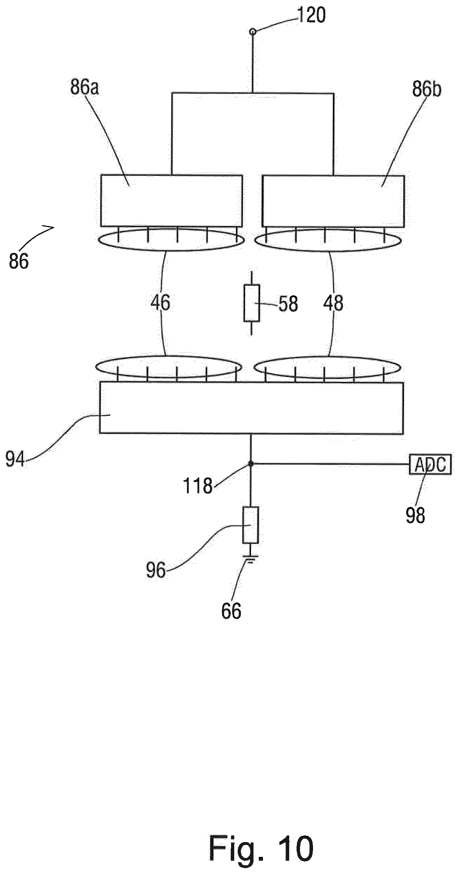

Neben dem hier angedeuteten Test können durch die Testeinrichtung bzw. durch einzelne Komponenten der Testeinrichtung weitere Tests durchgeführt werden. Eine Auswahl dieser Tests wird in Bezug auf Fig. 10 noch im Detail erläutert.

Fig. 7 zeigt ein zweites Ausführungsbeispiel der neuen Schutzeinrichtung. Das zweite Ausführungsbeispiel unterscheidet sich durch die Art und Anordnung des ersten Selektionselements, welches hier mit der Bezugsziffer 104 bezeichnet ist. Im Übrigen ist die Schutzeinrichtung identisch zu der Schutzeinrichtung gemäß dem ersten Ausführungsbeispiel, sodass im Folgenden nicht erneut auf die in Bezug zur Fig. 6 erläuterten Komponenten mit gleichen Bezugsziffern eingegangen wird.

Das erste Selektionselement 104 weist in diesem Ausführungsbeispiel drei logische Einheiten 104a, 104b, 104c auf. Die erste logische Einheit 104a ist dazu ausgebildet, die ersten Elektroden 46 wahlweise mit dem Messpotential 74 zu verbinden. Die zweite logische Einheit 104b ist dazu ausgebildet, die zweiten Elektroden 48 wahlweise mit einem Masseanschluss 66 zu verbinden. Die dritte logische Einheit 104c ist dazu ausgebildet, die ersten und zweiten Elektroden 46, 48 mit dem definierten Potential 70 zu verbinden.

Die erste, zweite und dritte logische Einheit 104a, 104b, 104c wirken dabei so zusammen, dass zyklisch eine erste Elektrode mit dem Messpotential 74 und eine zweite Elektrode mit dem Masseanschluss 66 verbunden ist, während die übrigen ersten und zweiten Elektroden mit dem definierten Potential 70 verbunden sind. Die erste, zweite und dritte logische Einheit 104a, 104b, 104c können auch wie in Bezug zum ersten Ausführungsbeispiel angedeutet, aus einer Vielzahl einzelner Schaltelemente zusammengesetzt sein. Beispielsweise kann das Selektionselement aus Schaltelementen des Typs ADG711 von Analog Devices aufgebaut sein, welche je vier unabhängigen SPST-(single pole/singe throw)-Schalter aufweisen. Mit vier solchen Schaltelementen ließe sich ein Selektionselement 104 realisieren, welches einen Sensor 22 mit 8x8-Sensorzellen (acht erste Elektroden; acht zweite Elektroden; 64 Zellen) ansteuern kann.

Die Besonderheit der drei logischen Einheiten 104a, 104b, 104c gegenüber den zwei logischen Einheiten 86a, 86b gemäß dem Ausführungsbeispiel aus Fig. 6 ist darin zu sehen, dass die logischen Einheiten 104a, 104b, 104c unabhängig voneinander angeordnet werden können. Insbesondere können die erste und zweite logische Einheit 104a, 104b losgelöst von der Messelektronik sein, wie es hier durch die Anschlüsse 106a-c angedeutet ist. So sind in einem besonders bevorzugten Ausführungsbeispiel die erste und die zweite logische Einheit 104a, 104b im Sensor 22 integriert und von der Messelektronik losgelöst. Die erste und die zweite logische Einheit 104a, 104b könnten demnach bereits vorhandene Selektionselemente eines bestehenden Sensors 22 sein, die vorteilhaft weiterverwendet werden können und lediglich um die neue Messelektronik ergänzt werden. Das Ansteuern der bereits vorhandenen logischen Elemente 104a, 104b würde dann durch die neue Messelektronik erfolgen, wie es durch die Anschlüsse 106a-c angedeutet ist. Vorteilhaft dabei ist, dass die neue Messelektronik einschließlich der neuen Testeinrichtung als separate Einheit ausgebildet sein kann, beispielsweise als eine Aufsteckplatine zur Ergänzung einer bisherigen Elektronik eines Sensors. Auf diese Weise können bestehende Sensoren leicht und kostengünstig um die neue Funktionalität, insbesondere eine verbesserte Messung der einzelnen Zellen, ergänzt werden.

Eine solche Zusatzplatine würde dann lediglich eine dritte logische Einheit 104c, einen Impedanzwandler 78 und eine Steuer-/Auswerteeinheit 90 sowie eine Testeinrichtung mit einem zweiten Selektionselement 94 und einem Widerstand 96 umfassen. Über nach außen geführte Anschlüsse könnte die Zusatzplatine mit der Elektronik eines bestehenden Sensors verknüpft werden.

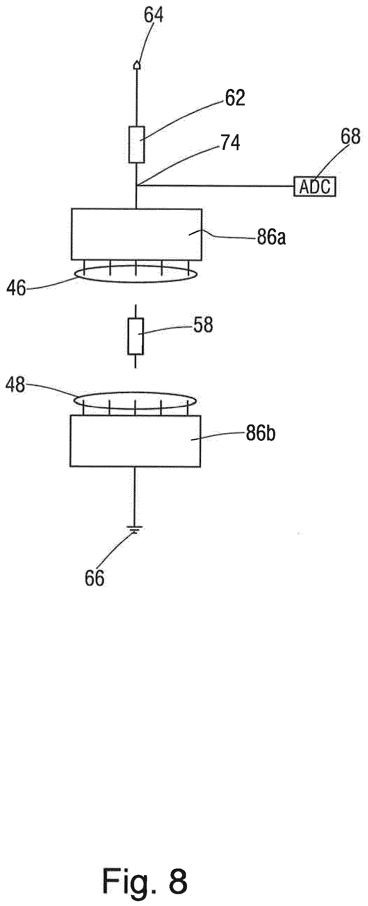

Fig. 8 zeigt ein vereinfachtes Ersatzschaltbild einer Messschaltung gemäß den Ausführungsbeispielen nach Fig. 6 und 7. Gleiche Bezugszeichen bezeichnen dabei gleiche Teile.

Das erste Selektionselement 86 ist hier durch zwei Multiplexer dargestellt. Ein Multiplexer ist eine Selektionsschaltung, mit der aus einer Anzahl von Eingangssignalen eines ausgewählt und an einen Ausgang durchgeschaltet werden kann.

In einem bevorzugten Ausführungsbeispiel schalten die Multiplexer zyklisch von einem Eingang zum nächsten, sodass der elektrische Widerstand 58 einer Sensorzelle zusammen mit dem Vorwiderstand 62 einen Spannungsteiler zwischen einem Anschluss zum Aufnehmen eines Messpotentials 64 und einem Masseanschluss 66 bildet.

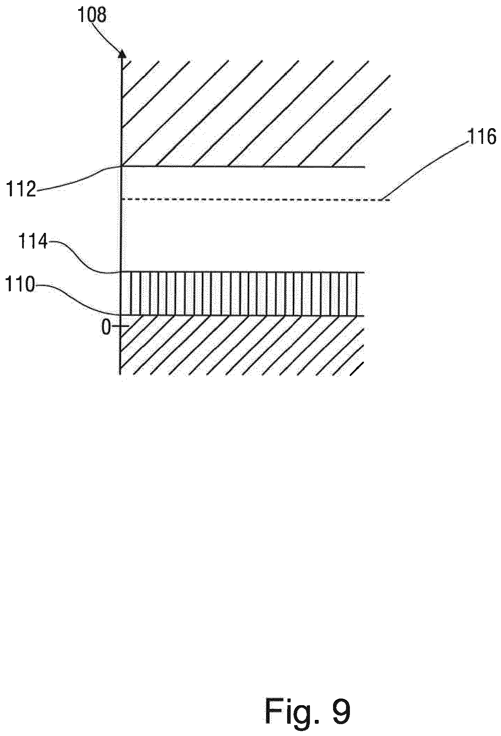

Die Spannung, die sich am Punkt 74 einstellt, wird vom ersten Analog-Digital-Konverter 68 gemessen und zur Bestimmung des von der Belastung der Sensorzelle abhängigen elektrischen Widerstands 58 verwendet. In Abhängigkeit der am Punkt 74 gemessenen Spannung wird somit das Ausgangssignal bestimmt, welches für die jeweilige Sensorzelle ausgegeben wird. Der Zusammenhang zwischen dem vom ersten Analog-Digital-Konverter 68 gemessenen Spannungswert und dem Ausgangssignal wird mit Bezug auf Fig. 9 im Folgenden näher erläutert.

Die Fig. 9 zeigt in einem Diagramm den Zusammenhang zwischen der gemessenen Spannung und dem Ausgangssignal. Die Achse 108 repräsentiert die gemessene Spannung und die angrenzenden Flächen repräsentieren die Art des Ausgangssignals. Mit den Bezugsziffern 110, 112 und 114 sind ein erster, zweiter und dritter Schwellwert bezeichnet, an denen sich der Zustand des Ausgangssignals ändert. Liegt der gemessene Spannungswert unterhalb des ersten Schwellwerts 110, wird eine Fehlerreaktion ausgelöst. Gründe für die Unterschreitung des ersten Schwellwerts 110 können beispielsweise ein Querschluss einer Elektrode auf Masse oder das Eindringen von Flüssigkeit in den Sensor sein. Befindet sich der gemessene Spannungswert oberhalb des zweiten Schwellwerts 112, wird ebenfalls von einem Fehler ausgegangen. Gründe für das Überschreiten des zweiten Schwellwerts 112 können unter anderem Alterung, Korrosion oder mechanischer Verschleiß der Sensorzellen sowie Drift sein. Darüber hinaus kann eine schlechte Verbindung oder Trennung der Elektroden oder ein Stuck-at-High-Fehler einer Elektrode vorliegen.

Befindet sich der Messwert hingegen zwischen dem ersten Schwellwert 110 und dem zweiten Schwellwert 112, wird eine ordnungsgemäße Messung angenommen und anhand des dritten Schwellwerts 114 zwischen einer betätigten und einer nichtbetätigten Sensorzelle unterschieden. Unterschreitet der gemessene Spannungswert den dritten Schwellwert 114 (kleiner Widerstand), wird eine Betätigung der Sensorzelle angenommen. Überschreitet der gemessene Spannungswert den dritten Schwellwert 114 (großer Widerstand), gilt die Sensorzelle als unbetätigt.

Mit der Bezugsziffer 116 ist ein Spannungswert angedeutet, der eine unbelastete Sensorzelle repräsentiert. Driftet dieser Wert der unbelasteten Sensorzelle nach unten, wird die Sensorzelle druckempfindlicher und Betätigungen werden schon bei weniger Belastung erkannt. Dies verursacht keinen Sicherheitsverlust. Drifte der Spannungswert nach oben, greift der zwei Schwellwert 112, bevor ein Fehler auftreten kann.

Fig. 10 zeigt ein Ersatzschaltbild der neuen Testeinrichtung gemäß den Ausführungsbeispielen aus Fig. 6 und 7.

Mit der dargestellten Beschaltung können mehrere Schalttests durchgeführt werden, anhand derer die verschiedenen Komponenten der Messelektronik auf ihre Funktionsfähigkeit in überprüft werden können. In der oberen Hälfte der Schaltung gemäß Fig. 10 ist ein erstes Selektionselement 86 dargestellt, welches in eine erste logische Einheit 86a und eine zweite logische Einheit 86b untergliedert ist. Es versteht sich, dass eine entsprechende Untergliederung in drei logische Einheiten 104a, 104 und 104c gemäß dem zweiten Ausführungsbeispiel ebenfalls möglich wäre. Die untere Hälfte der Schaltung gemäß Fig. 10 zeigt die Testeinrichtung mit einem zweiten Selektionselement 94, einem zweiten Analog-Digital-Konverter 98 und dem Widerstand 96. Die erste logische Einheit 86a ist mit den ersten Elektroden 46 verbunden und die zweite logische Einheit 86b ist mit den zweiten Elektroden 48 verbunden. Das zweite Selektionselement 94 ist sowohl mit den ersten Elektroden 46 als auch mit den zweiten Elektroden 48 verbunden.

Eine derartige Belegung ermöglicht es, dass in einem ersten Schalttest das erste Selektionselement 86 und das zweite Selektionselement 94 so geschaltet werden, dass diese gleichzeitig mit derselben Elektrode aus der Vielzahl der ersten Elektroden 46 und der Vielzahl zweiter Elektroden 48 verbunden sind. Dadurch wird der elektrische Widerstand 58 "ausgeklammert" und das erste Selektionselement 86 und das zweite Selektionselement 94 sind unmittelbar miteinander verbunden. Am Messpunkt 118 müsste sich dann ein definierter Spannungswert einstellen, der sich aus der am Anschluss 120 anliegenden Spannung und dem Widerstand 96 ergibt. Weicht der durch den zweiten Analog-Digital-Konverter 98 bestimmte Wert von diesem Erwartungswert ab, so ist auf einen Fehler des ersten Selektionselements 86 oder ein fehlerhaftes Schalten des ersten Selektionselements 86 zu schließen.

In einem zweiten Schalttest wird mit der vorliegenden Testeinrichtung überprüft, ob zwischen den Reihen oder Spalten Querschlüsse vorhanden sind. Hierbei werden das erste und das zweite Selektionselement 86 ,94 zyklisch so geschaltet, dass sich ein Spannungsteiler über den elektrischen Widerstand 58 und den Widerstand 96 einstellt. Ist der vom zweiten Analog-Digital-Konverter 98 gemessene Spannungswert zu niedrig, wird ein Fehler angenommen, da dies auf fehlende Verbindung von Elektroden hindeutet. Ein zu hoher Spannungswert am Messpunkt 118 deutet auf Querschlüsse zwischen den Elektroden, Querschlüsse auf Masse, fertigungsbedingte Elektrodenfehler oder auf Eindringen von Flüssigkeit hin, sodass ebenfalls ein Fehlerzustand angezeigt wird.

Es versteht sich, dass neben dem ersten und dem zweiten Schalttest weitere Tests durch die Testeinrichtung oder durch einzelne Komponenten der Testeinrichtung möglich sind. Beispielsweise kann durch entsprechende Beschaltung und Hinterlegung von Erwartungswerten auch der Operationsverstärker auf seine Funktionsfähigkeit getestet werden.

## Patentansprüche

1. Schutzeinrichtung (10, 12) mit einem druckempfindlichen Sensor (22), der eine Vielzahl von ersten Elektroden (46) und eine Vielzahl von zweiten Elektroden (48) aufweist, wobei jede erste Elektrode (46a-46h) jede zweite Elektrode (48a-48e) in einem zugehörigen Kopplungsort (50) überlappt und wobei jede erste Elektrode (46a-46h) in dem zugehörigen Kopplungsort (50) durch ein druckempfindliches Material (56) von der zugehörigen zweiten Elektrode beabstandet ist, sodass sich bei Einwirken einer Kraft an dem Kopplungsort (50) ein elektrischer Widerstand (58) zwischen der zughörigen ersten Elektrode (46g, 52) und der zugehörigen zweiten Elektrode (48d, 54) verändert,
sowie mit einer Messelektronik, die mit der Vielzahl von ersten Elektroden (46) und der Vielzahl von zweiten Elektroden (48) gekoppelt ist und dazu ausgebildet ist, nacheinander den elektrischen Widerstand (58) an den zugehörigen Kopplungsorten (50) zu bestimmen, und
mit einer Auswerteeinheit (90), die dazu ausgebildet ist, in Abhängigkeit der gemessenen elektrischen Widerstände (58) ein Ausgangssignal bereitzustellen,
wobei die Messelektronik so eingerichtet ist, für die Bestimmung des elektrischen Widerstands (58) an einem Kopplungsort (50) über die zughörige erste Elektrode (52) und die zugehörige zweite Elektrode (54) die weiteren ersten Elektroden und die weiteren zweiten Elektroden mit einem gemeinsamen Anschluss zum Aufnehmen eines definierten Potentials (72) zu verbinden, um eine isolierte Messung des elektrischen Widerstands (58) an dem Kopplungsort (50) zu ermöglichen,
wobei die Auswerteeinheit (90) dazu ausgebildet ist, die gemessenen Widerstände anhand einer gemessenen Spannung zu bestimmen und in Abhängigkeit davon zwischen drei Ausgangssignalen zu unterscheiden, um für jeden Kopplungsort (50) ein erstes, ein zweites oder ein drittes Ausgangssignal bereitzustellen, und
wobei die Auswerteeinheit (90) dazu ausgebildet, das erste Ausgangsignal auszugeben, wenn die gemessene Spannung einen ersten Schwellwert (110) unterschreitet oder einen zweiten Schwellwert (112) überschreitet, das zweite Signal auszugeben, wenn die gemessene Spannung den ersten Schwellwert (110) überschreitet und einen dritten Schwellwert (114), welcher zwischen dem ersten Schwellwert (110) und dem zweiten Schwellwert liegt (112), unterschreitet, und das dritte Ausgangsignal auszugeben, wenn die gemessene Spannung den dritten Schwellwert (114) überschreitet und den zweiten Schwellwert (112) unterschreitet.

2. Schutzeinrichtung gemäß Anspruch 1, wobei die Messelektronik ein erstes Selektionselement (86) aufweist, das dazu ausgebildet ist, für die Bestimmung des elektrischen Widerstands (58) die zugehörige erste Elektrode (46g, 52) mit einem Anschluss zum Aufnehmen eines Messpotentials (64) zu verbinden und die zugehöriger zweite Elektrode (48d, 54) mit einem Masseanschluss (66) zu verbinden.

3. Schutzeinrichtung gemäß Anspruch 2, wobei der Anschluss zum Aufnehmen des definierten Potentials (72) mit dem Anschluss zum Aufnehmen des Messpotentials (64) gekoppelt ist, sodass das definierte Potential (70) betragsmäßig dem Messpotential (74) entspricht.

4. Schutzeinrichtung gemäß einem der Ansprüche 2 oder 3, wobei die Messelektronik einen Impedanzwandler (78) aufweist, der eingangsseitig mit dem Anschluss zum Aufnehmen eines Messpotentials (64) verbunden ist und ausgangsseitig mit dem Anschluss zum Aufnehmen des definierten Potentials (72) verbunden ist.

5. Schutzeinrichtung gemäß Anspruch 4, wobei der Impedanzwandler ein Operationsverstärker (78) ist, der einen invertierenden Eingang (82), einen nicht-invertierenden Eingang (76) und einen Ausgang (80) aufweist, wobei der Ausgang (80) auf den invertierenden Eingang (82) zurückgekoppelt ist.

6. Schutzeinrichtung gemäß einem der Ansprüche 2 bis 5, wobei die Messelektronik einen ersten Analog-Digital-Konverter (68) aufweist und das erste Selektionselement (86) dazu ausgebildet ist, die zughörige erste Elektrode (46g, 52) mit dem ersten Analog-Digital-Konverter (68) zu verbinden.

7. Schutzeinrichtung gemäß einem der Ansprüche 2 bis 6, wobei die Messelektronik eine Testeinrichtung mit einem zweiten Selektionselement (94, 104), einem Widerstand (96) und einem zweiten Analog-Digital-Konverter (98) aufweist, um Selbsttests durchzuführen.

8. Schutzeinrichtung gemäß Anspruch 7, wobei das zweite Selektionselement (94, 104) mit der Vielzahl erster Elektroden (46) und der Vielzahl zweiter Elektroden (48) gekoppelt ist und dazu ausgebildet ist, nacheinander jeweils eine Elektrode der Vielzahl erster Elektroden (46) und der Vielzahl zweiter Elektroden (48) parallel zu dem Widerstand (96) mit dem zweiten Analog-Digital-Konverter (98) zu verbinden.

9. Schutzeinrichtung gemäß einem der Ansprüche 7 oder 8, wobei die Testeinrichtung dazu eingerichtet ist, das erste Selektionselement (86) und das zweite Selektionselement (94, 104) zyklisch auf jeweils die gleiche Elektrode der Vielzahl von ersten Elektroden (46) und der Vielzahl von zweiten Elektroden (48) zu schalten, um einen ersten Schalttest durchzuführen.

10. Schutzeinrichtung gemäß einem der Ansprüche 7 oder 8, wobei die Testeinrichtung dazu eingerichtet ist, das erste Selektionselement (86; 104) und das zweite Selektionselement (94, 104) zyklisch auf die Vielzahl von ersten Elektroden (46) und die Vielzahl von zweiten Elektroden (48) zu schalten, sodass zwischen dem ersten (86; 104) und dem zweiten Selektionselement (94) jeder spezifische Widerstand (58) eines Kopplungsortes (50) anliegt, um einen zweiten Schalttest durchzuführen.

11. Schutzeinrichtung gemäß einem der Ansprüche 1 bis 10, wobei das erste Ausgangsignal einem Fehlersignal entspricht, das zweite Ausgangssignal einem Signal entspricht, welches einen betätigen Zustand an einem Kopplungsort (50) anzeigt, und das dritte Ausgangssignal einem Signal entspricht, welches einen nichtbetätigten Zustand am Kopplungsort (50) anzeigt.

12. Schutzeinrichtung gemäß einem der Ansprüche 1 bis 11, wobei die Auswerteeinheit (90) mehrkanalig redundant ausgebildet ist.

13. Verfahren zum Bestimmen eines Ausgangssignals eines druckempfindlichen Sensors (22), der eine Vielzahl von ersten Elektroden (46) und eine Vielzahl von zweiten Elektroden (48) aufweist, wobei jede erste Elektrode (46a-46h) jede zweite Elektrode (48a-48e) in einem zugehörigen Kopplungsort (50) überlappt und wobei jede erste Elektrode (46g, 52) in dem zugehörigen Kopplungsort (50) durch ein druckempfindliches Material (56) von der zugehörigen zweiten Elektrode (48d, 54) beabstandet ist, sodass sich bei Einwirken einer Kraft an dem Kopplungsort (50) ein elektrischer Widerstand zwischen der zughörigen ersten Elektrode (46g, 52) und der zugehörigen zweiten Elektrode (48d,54) verändert, das Verfahren umfasst folgende Schritte:
- Bereitstellen einer Messelektronik, die mit der Vielzahl von ersten Elektroden (46) und der Vielzahl von zweiten Elektroden (48) gekoppelt ist und nacheinander den elektrischen Widerstand (58) an den zugehörigen Kopplungsorten (50) bestimmt, und
- Bereitstellen eines Ausgangssignals in Abhängigkeit der gemessenen elektrischen Widerstände (58) durch eine Auswerteeinheit (90),
wobei die Messelektronik so eingerichtet ist, für die Bestimmung des elektrischen Widerstands (58) an einem Kopplungsort (50) über die zughörige erste Elektrode (46g, 52) und die zugehörige zweite Elektrode (48d,54) die weiteren ersten Elektroden (46a-46f; 46h) und die weiteren zweiten Elektroden (48a-48c; 48e) mit einem gemeinsamen Anschluss zum Aufnehmen eines definierten Potentials (72) zu verbinden, um eine isolierte Messung des elektrischen Widerstands (58) an dem Kopplungsort (50) zu ermöglichen,
wobei die Auswerteeinheit (90) dazu ausgebildet ist, die gemessenen Widerstände anhand einer gemessenen Spannung zu bestimmen und in Abhängigkeit davon zwischen drei Ausgangssignalen zu unterscheiden, um für jeden Kopplungsort (50) ein erstes, ein zweites oder ein drittes Ausgangssignal bereitzustellen, und
wobei die Auswerteeinheit (90) dazu ausgebildet, das erste Ausgangsignal auszugeben, wenn die gemessene Spannung einen ersten Schwellwert (110) unterschreitet oder einen zweiten Schwellwert (112) überschreitet, das zweite Signal auszugeben, wenn die gemessene Spannung den ersten Schwellwert (110) überschreitet und einen dritten Schwellwert (114), welcher zwischen dem ersten Schwellwert (110) und dem zweiten Schwellwert liegt (112), unterschreitet, und das dritte Ausgangsignal auszugeben, wenn die gemessene Spannung den dritten Schwellwert (114) überschreitet und den zweiten Schwellwert (112) unterschreitet.

## Claims

1. A safety device (10, 12) comprising:
a pressure sensitive sensor (22) having a plurality of first electrodes (46) and a plurality of second electrodes (48), wherein each first electrode (46a-46h) overlaps each second electrode (48a-48e) in an associated coupling site (50) and wherein each first electrode (46a-46h) in the associated coupling site (50) is spaced apart from the associated second electrode by a pressure sensitive material (56), so that upon application of a force at the coupling site (50), an electrical resistance (58) between the associated first electrode (46g, 52) and the associated second electrode (48d, 54) changes;
a measuring circuitry coupled to said plurality of first electrodes (46) and said plurality of second electrodes (48) and configured to successively determine the electrical resistance (58) at associated coupling sites (50); and
an evaluation unit (90) configured to provide an output signal in response to the measured electrical resistances (58),
wherein the measuring circuitry is configured, for determining the electrical resistance (58) at a coupling site (50) via the associated first electrode (52) and the associated second electrode (54), to connect the further first electrodes and second electrodes to a terminal for receiving a defined potential (72) to enable isolated measurement of the electrical resistance (58) at the coupling site (50),
wherein the evaluation unit (90) is configured to determine the measured resistances from a measured voltage and to provide for each coupling site (50) a first, second or third output signal in dependence on the measured voltage, and
wherein the evaluation unit (90) is configured to output the first output signal, when the measured voltage falls below a first threshold value (110) or exceeds a second threshold value (112), to output the second signal, when said measured voltage exceeds said first threshold (110) and falls below a third threshold (114) lying between said first threshold (110) and said second threshold (112), and output said third output, when said measured voltage exceeds said third threshold (114) and falls below said second threshold (112).

2. The safety device according to claim 1, wherein the measuring circuitry comprises a first selection element (86) configured to connect the associated first electrode (46g, 52) to a terminal for receiving a measurement potential (64) for determining the electrical resistance (58) and to connect the associated second electrode (48d, 54) to a ground terminal (66).

3. The safety device according to claim 2, wherein the terminal for receiving the defined potential (72) is coupled to the terminal for receiving the measuring potential (64) so that the defined potential (70) corresponds in amount to the measuring potential (74).

4. The safety device according to claims 2 or 3, wherein the measuring circuitry comprises an impedance converter (78) which is connected on an input side to the terminal for receiving a measuring potential (64) and is connected on an output side to the terminal for receiving the defined potential (72).

5. The safety device according to claim 4, wherein the impedance converter is an operational amplifier (78) having an inverting input (82), a non-inverting input (76) and an output (80), the output (80) being feedback to the inverting input (82).

6. The safety device according to any one of claims 2 to 5, wherein the measuring circuitry comprises a first analog-to-digital converter (68), and the first selection element (86) is configured to connect the associated first electrode (46g, 52) to the first analog-to-digital converter (68).

7. The safety device according to any one of claims 2 to 6, wherein the measuring circuitry comprises testing means including a second selection element (94, 104), a resistor (96) and a second analog-to-digital converter (98) for performing self-tests.

8. The safety device according to claim 7, wherein the second selection element (94, 104) is coupled to the plurality of first electrodes (46) and the plurality of second electrodes (48) and is configured to successively connect one electrode of each of the plurality of first electrodes (46) and the plurality of second electrodes (48) in parallel with the resistor (96) to the second analog-to-digital converter (98).

9. The safety device according to claims 7 or 8, wherein the testing means is configured to cyclically switch the first selection element (86) and second selection element (94, 104) to the same electrode of each of the plurality of first electrodes (46) and the plurality of second electrodes (48) to perform a first switching test.

10. The safety device according to claims 7 or 8, wherein the testing means is configured to cyclically switch the first selection element (86; 104) and the second selection element (94, 104) to the plurality of first electrodes (46) and the plurality of second electrodes (48) such that between the first (86; 104) and the second selection element (94) each specific resistances (58) of a coupling site (50) is present to perform a second switching test.

11. The safety device according to any one of the claims 1 to 10, wherein the first output signal corresponds to an error signal, the second output signal corresponds to a signal indicative of an actuated state at a coupling site (50), and the third output signal corresponds to a signal indicative of an unactuated state at the coupling site (50).

12. The safety device according to any one of the claims 1 to 11, wherein the evaluation unit (90) is multi-channel redundant.

13. A method for determining an output signal of a pressure sensitive sensor (22) comprising a plurality of first electrodes (46) and a plurality of second electrodes (48), wherein each first electrode (46a-46h) overlaps each second electrode (48a-48e) in an associated coupling site (50) and wherein each first electrode (46g, 52) in the associated coupling site (50) is spaced apart from the associated second electrode (48d, 54) by a pressure sensitive material (56) such that upon application of a force at the coupling site (50) an electrical resistance changes between the associated first electrode (46g, 52) and the associated second electrode (48d, 54), the method comprising the steps of:
- providing a measuring circuitry coupled to the plurality of first electrodes (46) and the plurality of second electrodes (48) and successively determining the electrical resistance (58) at the associated coupling sites (50), and
- providing an output signal as a function of the measured electrical resistances (58) by an evaluation unit (90),
wherein the measuring circuitry is configured, for determining the electrical resistance (58) at a coupling site (50) via the associated first electrode (46g, 52) and the associated second electrode (48d, 54), to connect the further first electrodes (46a-46f; 46h) and the further second electrodes (48a-48c; 48e) to a terminal for receiving a defined potential (72) to enable isolated measurement of the electrical resistance (58) at the coupling site (50),
wherein the evaluation unit (90) is configured to determine the measured resistances from a measured voltage and to provide for each coupling site (50) a first, second or third output signal in dependence on the measured voltage, and
wherein the evaluation unit (90) is configured to output the first output signal, when the measured voltage falls below a first threshold value (110) or exceeds a second threshold value (112), to output the second signal, when said measured voltage exceeds said first threshold (110) and falls below a third threshold (114) lying between said first threshold (110) and said second threshold (112), and output said third output, when said measured voltage exceeds said third threshold (114) and falls below said second threshold (112).

## Revendications

1. Dispositif de protection (10, 12) comprenant un capteur (22) sensible à la pression, lequel possède une pluralité de premières électrodes (46) et une pluralité de deuxièmes électrodes (48), chaque première électrode (46a-46h) chevauchant chaque deuxième électrode (48a-48e) en un point de couplage (50) associé et chaque première électrode (46a-46h) dans le point de couplage (50) associé étant espacée de la deuxième électrode associé par un matériau sensible à la pression (56), de sorte que lors de l'action d'une force au niveau du point de couplage (50), une résistance électrique (58) entre la première électrode (46g, 52) associée et la deuxième électrode (48d, 54) change,
et comprenant également une électronique de mesure, laquelle est connectée à la pluralité de premières électrodes (46) et à la pluralité de deuxièmes électrodes (48) et est configurée pour déterminer successivement la résistance électrique (58) aux points de couplage (50) associés, et
comprenant une unité d'interprétation (90), laquelle est configurée pour fournir un signal de sortie en fonction des résistances électriques (58) mesurées,
l'électronique de mesure étant conçue de telle sorte, pour la détermination de la résistance électrique (58) à un point de couplage (50) par le biais de la première électrode (52) associée et pour relier la deuxième électrode (54) associée, les autres premières électrodes et les autres deuxièmes électrodes avec une borne commune en vue d'enregistrer un potentiel (72) défini, afin de rendre possible une mesure isolée de la résistance électrique (58) au point de couplage (50),
l'unité d'interprétation (90) étant configurée pour déterminer les résistances mesurées à l'aide d'une tension mesurée et, en fonction de celles-ci, faire une différentiation entre trois signaux de sortie afin de fournir, pour chaque point de couplage (50), un premier, un deuxième ou un troisième signal de sortie, et
l'unité d'interprétation (90) étant configurée pour délivrer le premier signal de sortie lorsque la tension mesurée devient inférieure à une première valeur de seuil (110) ou devient supérieure à une deuxième valeur de seuil (112), délivrer le deuxième signal lorsque la tension mesurée devient supérieure à la première valeur de seuil (110) et devient inférieure à une troisième valeur de seuil (114), laquelle se trouve entre la première valeur de seuil (110) et la deuxième valeur de seuil (112), et délivrer le troisième signal de sortie lorsque la tension mesurée devient supérieure à la troisième valeur de seuil (114) et devient inférieure à la deuxième valeur de seuil (112).

2. Dispositif de protection selon la revendication 1, l'électronique de mesure possédant un premier élément de sélection (86), lequel est configuré, pour la détermination de la résistance électrique (58), relier la première électrode (46g, 52) associée à une borne servant à enregistrer un potentiel de mesure (64) et relier la deuxième électrode (48d, 54) associée à une borne de masse (66).

3. Dispositif de protection selon la revendication 2, la borne servant à enregistrer le potentiel défini (72) étant connectée à la borne servant à enregistrer le potentiel de mesure (64), de sorte que le potentiel défini (70) correspond en valeur absolue au potentiel de mesure (74).

4. Dispositif de protection selon l'une des revendications 2 ou 3, l'électronique de mesure possédant un convertisseur d'impédance (78) dont l'entrée est reliée à la borne servant à enregistrer le potentiel de mesure (64) et dont la sortie est reliée à la borne servant à enregistrer le potentiel défini (72).

5. Dispositif de protection selon la revendication 4, le convertisseur d'impédance étant un amplificateur opérationnel (78) qui possède une entrée inverseuse (82), une entrée non inverseuse (76) et une sortie (80), la sortie (80) étant reliée en contre-réaction à l'entrée inverseuse (82).

6. Dispositif de protection selon l'une des revendications 2 à 5, l'électronique de mesure possédant un premier convertisseur analogique-numérique (68) et le premier élément de sélection (86) étant configuré pour relier la première électrode (46g, 52) associée au premier convertisseur analogique-numérique (68).

7. Dispositif de protection selon l'une des revendications 2 à 6, l'électronique de mesure possédant un dispositif de test pourvu d'un deuxième élément de sélection (94, 104), d'une résistance (96) et d'un deuxième convertisseur analogique-numérique (98) afin d'effectuer des autotests.

8. Dispositif de protection selon la revendication 7, le deuxième élément de sélection (94, 104) étant connecté à la pluralité de premières électrodes (46) et à la pluralité de deuxièmes électrodes (48) et étant configuré pour relier successivement au deuxième convertisseur analogique-numérique (98), en parallèle avec la résistance (96), respectivement une électrode de la pluralité de premières électrodes (46) et de la pluralité de deuxièmes électrodes (48).

9. Dispositif de protection selon l'une des revendications 7 ou 8, le dispositif de test étant conçu pour commuter cycliquement le premier élément de sélection (86) et le deuxième élément de sélection (94, 104) respectivement sur la même électrode de la pluralité de premières électrodes (46) et de la pluralité de deuxièmes électrodes (48) afin d'effectuer un premier test de commutation.

10. Dispositif de protection selon l'une des revendications 7 ou 8, le dispositif de test étant conçu pour commuter cycliquement le premier élément de sélection (86, 104) et le deuxième élément de sélection (94, 104) sur la pluralité de premières électrodes (46) et la pluralité de deuxièmes électrodes (48), de sorte que chaque résistance spécifique (58) d'un point de couplage (50) se trouve entre le premier (86, 104) et le deuxième élément de sélection (94), afin d'effectuer un deuxième test de commutation.

11. Dispositif de protection selon l'une des revendications 1 à 10, le premier signal de sortie correspondant à un signal d'erreur, le deuxième signal de sortie correspondant à un signal qui indique un état actionné au niveau d'un point de couplage (50) et le troisième signal de sortie correspondant à un signal qui indique un état non actionné au niveau d'un point de couplage (50).

12. Dispositif de protection selon l'une des revendications 1 à 11, l'unité d'interprétation (90) étant de configuration redondante à plusieurs canaux.

13. Procédé de détermination d'un signal de sortie d'un capteur sensible à la pression (22), lequel possède une pluralité de premières électrodes (46) et une pluralité de deuxièmes électrodes (48), chaque première électrode (46a-46h) chevauchant chaque deuxième électrode (48a-48e) en un point de couplage (50) associé et chaque première électrode (46g, 52) dans le point de couplage (50) associé étant espacée de la deuxième électrode (48d, 54) associée par un matériau sensible à la pression (56), de sorte que lors de l'action d'une force au niveau du point de couplage (50), une résistance électrique entre la première électrode (46g, 52) associée et la deuxième électrode (48d, 54) change, le procédé comprenant les étapes suivantes :
- fourniture d'une électronique de mesure, laquelle est connectée à la pluralité de premières électrodes (46) et à la pluralité de deuxièmes électrodes (48) et détermine successivement la résistance électrique (58) aux points de couplage (50) associés, et
- fourniture d'un signal de sortie en fonction des résistances électriques (58) mesurées par une unité d'interprétation (90),
l'électronique de mesure étant conçue de telle sorte, pour la détermination de la résistance électrique (58) à un point de couplage (50) par le biais de la première électrode (46g, 52) associée et pour relier la deuxième électrode (48d, 54) associée, les autres premières électrodes (46a-46f ; 46h) et les autres deuxièmes électrodes (48a-48c ; 48e) avec une borne commune en vue d'enregistrer un potentiel (72) défini, afin de rendre possible une mesure isolée de la résistance électrique (58) au point de couplage (50),
l'unité d'interprétation (90) étant configurée pour déterminer les résistances mesurées à l'aide d'une tension mesurée et, en fonction de celles-ci, faire une différentiation entre trois signaux de sortie afin de fournir, pour chaque point de couplage (50), un premier, un deuxième ou un troisième signal de sortie, et
l'unité d'interprétation (90) étant configurée pour délivrer le premier signal de sortie lorsque la tension mesurée devient inférieure à une première valeur de seuil (110) ou devient supérieure à une deuxième valeur de seuil (112), délivrer le deuxième signal lorsque la tension mesurée devient supérieure à la première valeur de seuil (110) et devient inférieure à une troisième valeur de seuil (114), laquelle se trouve entre la première valeur de seuil (110) et la deuxième valeur de seuil (112), et délivrer le troisième signal de sortie lorsque la tension mesurée devient supérieure à la troisième valeur de seuil (114) et devient inférieure à la deuxième valeur de seuil (112).
